# EUROPEAN PATENT APPLICATION

(11) **EP 3 693 795 A1**
(43) Date of publication of application: **12.08.2020**
(21) Application number: 19155660.4
(22) Date of filing: 06.02.2019
(51) Int. Cl.: G03F 7/20, G05B 23/02, G05B 19/418

(54) **METHOD FOR DECISION MAKING IN A SEMICONDUCTOR MANUFACTURING PROCESS**

(71) Applicant: ASML Netherlands B.V., 5500 AH Veldhoven (NL)
(72) Inventor: HUBAUX, Arnaud, 5500 AH Veldhoven (NL)
(74) Representative: Peters, John Antoine

(57) **Abstract**

Described is a method and associated computer program and apparatuses for method for making a decision within a manufacturing process. The method comprises obtaining scanner data relating to one or more parameters of a lithographic exposure step of the manufacturing process and applying a decision model. The decision model outputs a value for each of one or more categorical indicators based on the scanner data, each categorical indicator being indicative of a quality of the manufacturing process. An action is decided upon (e.g., to inspect a substrate as a candidate for rework) based on a value of the categorical indicator.

## Description

### FIELD

The present invention relates to semiconductor manufacturing processes, in particular methods to make a decision, such as whether a substrate should be reworked, in a semiconductor manufacturing process.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

These tight control loops are generally based on metrology data obtained using a metrology tool measuring characteristics of the applied pattern or of metrology targets representing the applied pattern. In general the metrology tool is based on optical measurement of the position and/or dimensions of the pattern and/or targets. It is intrinsically assumed that these optical measurements are representative for a quality of the process of manufacturing of the integrated circuits.

In addition to control based on optical measurements, also e-beam based measurements may be performed; among which a so-called low voltage measurement using an e-beam tool (as offered by HMI) may be utilized. Such a low voltage contrast measurement is indicative of the quality of electrical contact between layers applied to the substrate.

To avoid loss of yield (complete loss and scrapping of a substrate), it is sometimes necessary to rework a substrate. Reworking essentially comprises the undoing of a previous exposure step, e.g., by stripping away all of an exposed layer, and re-exposing that layer. This may be necessary if it is determined that the exposed structures are out of specification in some way; for example if the overlay is too great, or CD is too small or insufficiently uniform, such that the device is likely to be non-functional. However, rework, and even checking a substrate to see if it requires reworking, incurs a significant throughput penalty. As such, an improved method for making decisions such as these (and others) is desired.

### SUMMARY

It is an object of the inventors to address the mentioned disadvantages of the state of the art.

In a first aspect of the invention there is provided a method for making a decision within a manufacturing process, the method comprising: obtaining scanner data relating to one or more parameters of a lithographic exposure step of the manufacturing process; applying a decision model which outputs a value for each of one or more categorical indicators based on the scanner data, each of the one or more categorical indicators being indicative of a quality of the manufacturing process; and deciding on an action based on a value of the categorical indicator.

In a second aspect of the invention, there is provided a method for constructing a decision model for making a decision within a manufacturing process, the method comprising: obtaining scanner data relating to one or more parameters of a lithographic exposure step of the manufacturing process; deriving one or more categorical indicators from the scanner data, each of the one or more categorical indicators being indicative of a quality of the manufacturing process based on at least one threshold value; and training the decision model on measurements performed on substrates having undergone said lithographic exposure step and corresponding decisions and/or categories assigned thereto, said training setting a value for each of said one or more threshold values, such that said decision model outputs an appropriate value for each of the one or more categorical indicators based on said scanner data.

### BRIEF DESCRIPTION OF THE DRAWINGS

Embodiments of the invention will now be described, by way of example only, with reference to the accompanying schematic drawings, in which:
Figure 1 depicts a schematic overview of a lithographic apparatus;
Figure 2 depicts a schematic overview of a lithographic cell;
Figure 3 depicts a schematic representation of holistic lithography, representing cooperation between three key technologies to optimize semiconductor manufacturing;
Figure 4 is a flowchart of a decision making method according to a first embodiment of the invention;
Figure 5; is a flow diagram of the parameter and indicator hierarchy within a fault detection and classification of an embodiment of the present invention; and
Figure 6 comprises three plots relating to a common timeframe: Figure 6(a) is a plot of raw parameter data, more specifically reticle align (RA) data, against time t; Figure 6(b) is an equivalent non-linear model function mf derived according to a method of an embodiment of the invention; and Figure 6(c) comprises the residual Δ between the plots of Figure 6(a) and Figure 6(b), illustrating a categorical indicator according to a method of an embodiment of the invention.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate; the term "light valve" can also be used in this context. Besides the classic mask (transmissive or reflective; binary, phase-shifting, hybrid, etc.), examples of other such patterning devices include:
- a programmable mirror array. More information on such mirror arrays is given in U. S. Patent Nos. 5,296,891 and 5,523,193, which are incorporated herein by reference.
- a programmable LCD array. An example of such a construction is given in U. S. Patent No. 5,229,872, which is incorporated herein by reference.

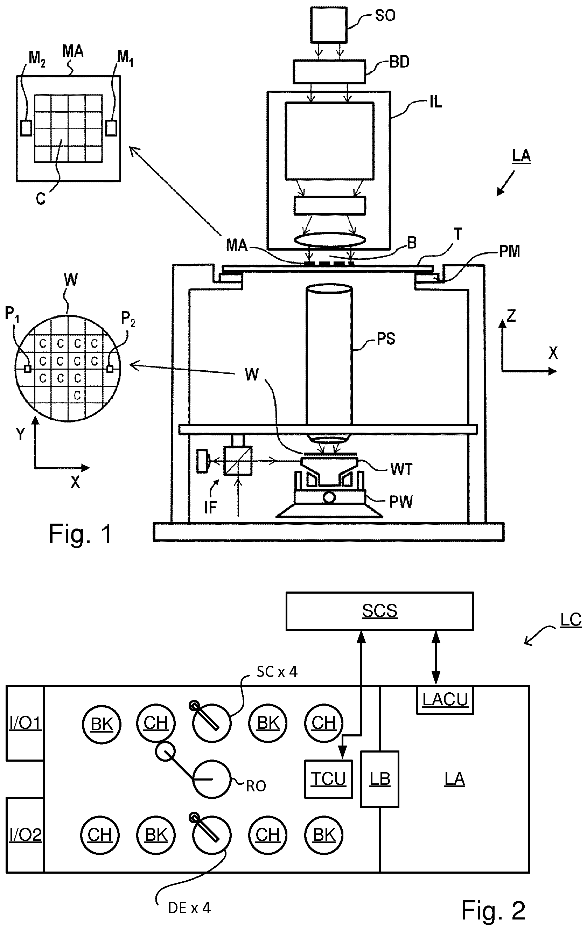

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a support structure (e.g., a mask table) MT constructed to support a patterning device (e.g., a mask) MA and connected to a first positioner PM configured to accurately position the patterning device MA in accordance with certain parameters, a substrate table (e.g., a wafer table) WT constructed to hold a substrate (e.g., a resist coated wafer) W and connected to a second positioner PW configured to accurately position the substrate in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illuminator IL receives a radiation beam from a radiation source SO, e.g. via a beam delivery system BD. The illumination system IL may include various types of optical components, such as refractive, reflective, magnetic, electromagnetic, electrostatic, or other types of optical components, or any combination thereof, for directing, shaping, or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system" PS.

The lithographic apparatus may be of a type wherein at least a portion of the substrate may be covered by a liquid having a relatively high refractive index, e.g., water, so as to fill a space between the projection system and the substrate - which is also referred to as immersion lithography. More information on immersion techniques is given in U. S. Patent No. 6,952,253 and in PCT publication No. WO99-49504, which are incorporated herein by reference.

The lithographic apparatus LA may also be of a type having two (dual stage) or more substrate tables WT and, for example, two or more support structure MT (not shown). In such "multiple stage" machines the additional tables / structures may be used in parallel, or preparatory steps may be carried out on one or more tables while one or more other tables are being used for exposing the design layout of the patterning device MA onto the substrate W.

In operation, the radiation beam B is incident on the patterning device (e.g., mask MA), which is held on the support structure (e.g., mask table MT), and is patterned by the patterning device MA. Having traversed the mask MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WT can be moved accurately, e.g., so as to position different target portions C in the path of the radiation beam B. Similarly, the first positioner PM and possibly another position sensor (which is not explicitly depicted in Figure 1) may be used to accurately position the mask MA with respect to the path of the radiation beam B. Mask MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks).

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

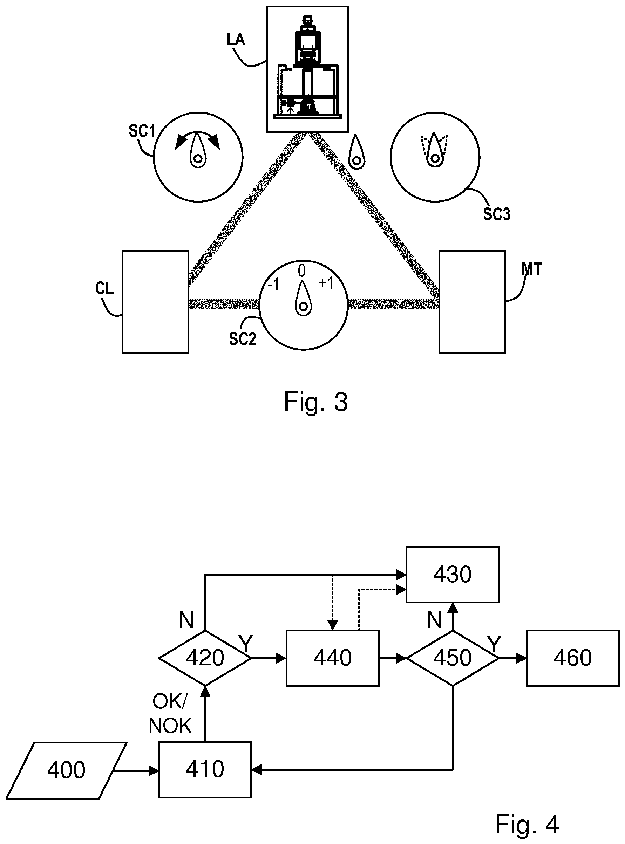

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double white arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT), so as to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

The lithographic apparatus LA is configured to accurately reproduce the pattern onto the substrate. The positions and dimensions of the applied features need to be within certain tolerances. Position errors may occur due to an overlay error (often referred to as "overlay"). The overlay is the error in placing a first feature during a first exposure relative to a second feature during a second exposure. The lithographic apparatus minimizes the overlay errors by aligning each wafer accurately to a reference prior to patterning. This is done by measuring positions of alignment marks on the substrate using an alignment sensor. More information on the alignment procedure can be found in U.S. Patent Application Publication No. US20100214550, which is incorporated herein by reference. Pattern dimensioning (e.g., CD) errors may, for example, occur when the substrate is not positioned correctly with respect to a focal plane of the lithographic apparatus. These focal position errors may be associated with un-flatness of a substrate surface. The lithographic apparatus minimizes these focal position errors by measuring the substrate surface topography prior to patterning using a level sensor. Substrate height corrections are applied during subsequent patterning to assure correct imaging (focusing) of the patterning device onto the substrate. More information on the level sensor system can be found in U.S. Patent Application Publication No. US20070085991, which is incorporated herein by reference.

Besides the lithographic apparatus LA and the metrology apparatus MT other processing apparatus may be used during IC production as well. An etching station (not shown) processes the substrates after exposure of the pattern into the resist. The etch station transfers the pattern from the resist into one or more layers underlying the resist layer. Typically etching is based on application of a plasma medium. Local etching characteristics may, for example, be controlled using temperature control of the substrate or directing the plasma medium using a voltage controlled ring. More information on etching control can be found in international Patent Application Publication No. WO2011081645 and U.S. Patent Application Publication No. US 20060016561 which are incorporated herein by reference.

During the manufacturing of the ICs, it is of great importance that the process conditions for processing substrates using processing apparatus, such as the lithographic apparatus or etching station, remain stable such that properties of the features remain within certain control limits. Stability of the process is of particular importance for features of the functional parts of the IC, i.e., the product features. To guarantee stable processing, process control capabilities need to be in place. Process control involves monitoring of processing data and implementation of means for process correction, e.g. control the processing apparatus based on characteristics of the processing data. Process control may be based on periodic measurement by the metrology apparatus MT, often referred to as "Advanced Process Control" (further also referenced to as APC). More information on APC can be found in U.S. Patent Application Publication No. US20120008127, which is incorporated herein by reference. A typical APC implementation involves periodic measurements on metrology features on the substrates to monitor and correct drifts associated with one or more processing apparatus. The metrology features reflect the response to process variations of the product features. The sensitivity of the metrology features to process variations may be different compared to the sensitivity of the product features. In that case, a so-called "Metrology To Device" offset (further also referenced to as MTD) may be determined. To mimic the behavior of product features, the metrology targets may incorporate segmented features, assist features or features with a particular geometry and/or dimension. A carefully designed metrology target should respond in a similar fashion to process variations as the product features. More information on metrology target design can be found in international Patent Application Publication No. WO 2015101458 which is incorporated herein by reference.

The term fingerprint may refer to a main (systematic) contributor ("latent factor") of a measured signal, and in particular a contributor connected to the performance impact on-wafer or to previous processing steps. Such a fingerprint can refer to substrate (grid) patterns (e.g. from alignment, leveling, overlay, focus, CD), field patterns (e.g., from intrafield alignment, leveling, overlay, focus, CD), substrate zone patterns (e.g., outermost radius of wafer measurements) or even patterns in scanner measurements related to wafer exposure (e.g., heating signature through-lot from reticle alignment measurements, temperature/pressure/servo profiles, etc.). Fingerprints may be comprised within a fingerprint collection, and may be encoded homogenously or heterogeneously therein.

Electrical measurement data is typically obtained after processing of substrates. Typically, when performing electrical metrology to obtain the electrical measurement data, all the dies on the substrates are measured using probes which make (near) contact to the circuits formed during the processing. Various types of measurements may be performed; voltage, current, resistance, capacitance and inductance measurements, for example. These measurements may be performed under different conditions (frequencies, voltage, current for example) and at a plurality of locations across the die. The electrical measurement may comprise an evaluation of whether a particular structure/ feature or device is functional (e.g., within specification). Alternatively, or in addition, the electrical measurement may be categorized according to "bin codes". An electrical measurement associated with a certain measured parameter (current, voltage, resistance, capacitance, inductance) at a certain condition is commonly referred to as a separate "bin code". Hence a typical electrical measurement across a die may be represented by a plurality of graphs, each graph representing a spatial distribution of values associated with a particular bin code. Throughout the text, "bin code" and "electrical characteristic" is used synonymously such that a value of a bin code associated with the substrate is referred to as a value of an electrical characteristic of the substrate. Electrical measurement data may also comprise bit asymmetry data or any other yield parameter.

The properties (minimum value, maximum value, variance or any other statistical measure) of the measured electrical characteristics are important indicators regarding the probability that a certain circuit on a die will be functional. Hence a strong relationship exists between the electrical characteristic and the yield of the process. Hence for yield control, electrical characteristic measurements are indispensable. However, they are also time consuming and are only performed at the end stage of the semiconductor manufacturing process (e.g. when options for correcting non-functional circuits are virtually absent).

Deciding which substrates should be inspected and/or reworked after exposure is an important consideration which will have an impact on throughput and yield. Errors in classification will result in yield wastage, as undetected out-of-speciation/non-functioning devices will be processed, or else too many false alarms, resulting in unnecessary checks and low efficiency.

Presently, statistical control techniques are applied on scanner data to set control limits for deciding which substrates should be inspected or reworked after exposure. However, the amount of data available for such analyses is extremely large. Without deep scanner knowledge, process knowledge and brute force data analytics techniques are required to identify the correct parameters, resulting in sub-optimal usage of the data. Statistical control techniques are blind to the physics of the Scanner. They mostly infer correlations from data, not causations. This makes it virtually impossible to understand the behavior of the Scanner and adapt it to prevent future issues. Whether manually, or supported by statistical binning, maintaining control limits per layer per indicator (e.g., key performance indicator or KPI) is extremely time-consuming and error-prone.

Additionally, there are two parties (the scanner manufacturer and the scanner user), neither of which necessarily has access to all the information required for efficient decision making. The scanner manufacturer will have knowledge of scanner sensitivities to features exposed on a particular layer, which are critical in properly defining reliable issue predictors. Such information is sensitive and typically is not shared with the user. Similarly, user sensitive information regarding manufacture of devices (e.g., ICs) using the scanner, such as reticle information, illumination mode, facet mirror rendering, is typically not shared with the manufacturer.

A fault detection and classification (FDC) is proposed which is physics driven, rather than statistics driven, and which does not require the sharing of sensitive data between scanner manufacturer and user. The proposal comprises identifying and isolating the relevant scanner parameters which have a known on-product impact. The parameters may comprise those which can be measured after each exposure (e.g. lens Zernike's) or during dedicated service steps (e.g. EUV collector far field image reconstruction for conventional pupil). New indicators are defined which aggregate scanner data into models that reflect the relevant physics of the scanner systems. Models which link these indicators to categorical on-product indicators are then defined. These models are used to make decisions during the manufacture process, for example, to decide whether a substrate should be checked and/or reworked. The decision making can be checked against the actual decision/categorization made, such as whether a rework was required or otherwise (i.e., the result of the checking is fed back, but not any sensitive metrology data) so as to validate and improve the decision making. In this way, the decision making can be tuned to a particular process without the sharing of user sensitive information.

As such, the proposed method comprises making a decision as part of a manufacturing process, the method comprising: obtaining scanner data relating to one or more parameters of a lithographic exposure step of the manufacturing process; deriving a categorical indicator from the scanner data, the categorical indicator being indicative of a quality of the manufacturing process; and deciding on an action based on the categorical indicator. Scanner data relating to one or more parameters of a lithographic exposure step may comprise data produced by the scanner itself, either during or in preparation of the exposure step, and/or generated by another station (e.g., a stand-alone measuring/alignment station) in a preparatory step for the exposure. As such, it does not necessarily have to be generated by or within the scanner. The term scanner is used generally to describe any lithographic exposure apparatus.

Figure 4 is a flowchart describing a method for making a decision in a manufacturing process utilizing a fault detection and classification (FDC) method/system as disclosed herein. Scanner data 400 is generated during exposure (i.e., exposure scanner data), or following a maintenance action (or by any other means). This scanner data 400, which is numerical in nature, is fed into the FDC system 410. The FDC system 410 converts the data into functional, scanner physics-based indicators and aggregates these functional indicators according to the system physics, so as to determine a categorical system indicator for each substrate. The categorical indicator could be binary, such as whether they meet a quality threshold (OK) or not (NOK). Alternatively there may be more than two categories (e.g., based on statistical binning techniques).

A check decision 420 is made to decide whether a substrate is to be checked/inspected, based on the scanner data 400, and more specifically, on the categorical indicator assigned to that substrate. If it is decided not to check the substrate, then the substrate is forwarded for processing 430. It may be that a few of these substrates still undergo a metrology step 440 (e.g., input data for a control loop and/or to validate the decision made at step 420). If a check is decided at step 420, the substrate is measured 440, and based on the result of the measurement, a rework decision 450 is made, to decide whether the substrate is to be reworked. In another embodiment, the rework decision is made based directly on the categorical quality value determined by FDC system 410 without the check decision. Depending on the result of the rework decision, the substrate is either reworked 460, or deemed to be OK and forwarded for processing 430. If the latter, this would indicate that the categorical indicator assigned to that substrate was incorrect/inaccurate. Note that the actual decisions illustrated (check and/or rework) are only exemplary, and other decisions could be based on the categorical values/advice output from the FDC, and/or the FDC output could be used to trigger an alarm (e.g., to indicate poor scanner performance).

The result of the rework decision 450 for each substrate is fed back to the FDC system 410. The FDC system can use this data to refine and validate its categorization and decision advice (the categorical indicator assigned). In particular, it can validate the assigned categorical indicator against the actual decision and, based on this, make any appropriate changes to the categorization criteria. For example, it can alter/set any categorization thresholds based on the validation. As such, all the rework decisions made by the user at step 450 should be fed back so that all check decisions of the FDC system 410 are validated. In this way, the categorical classifier within the FDC system 410 system is constantly trained during production, such that it receives more data and therefore becomes more accurate over time

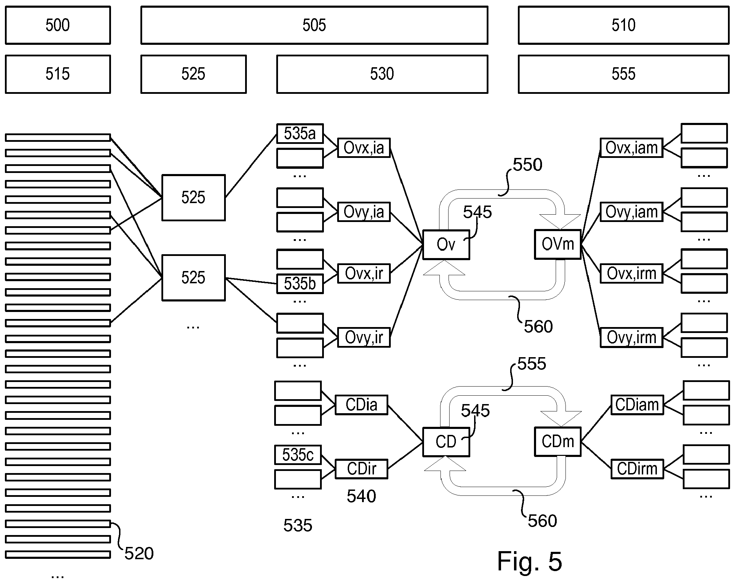

.Figure 5 is flow diagram describing how the FDC system operates in greater detail. The flow diagram is split into three main stages, the scanner stage 500, the FDC system stage 505 and the verification stage 510. The scanner stage 500 yields numerical scanner or exposure data 515, which comprises the numerous data parameter or indicators 520 generated by the scanner during exposure. This scanner data may comprise, for example, any data generated by the scanner which may have an impact on the decision on which the FDC system will advise. For example, the scanner data may comprise measurement data from measurements routinely taken during (or in preparation for) an exposure, for example reticle and or wafer alignment data, leveling data, lens aberration data, any sensor output data etc.. The scanner data may also comprise less routinely measured data (or estimated data), e.g., data from less routine maintenance steps, or extrapolated therefrom. A specific example such data may comprise source collector contamination data for EUV systems.

The FDC system stage 505 derives numerical functional indicators 525 based on the scanner data. These functional indicators 525 may be trained on production data so as to reflect actual usage of the scanner (e.g., temperature, exposure intervals etc.). The functional indicators 525 can be trained, for example, using statistical, linear/non-linear regression, deep learning or Bayesian learning techniques. Reliable and accurate functional indicators 525 may be constructed, for example, based on the scanner parameter data and the domain knowledge, where the domain knowledge may comprise a measure of deviation of the scanner parameters from nominal. Nominal may be based on known physics of the system/process and scanner behavior.

Models which link these indicators to on-product categorical indicators 530 can then be defined. The categorization can be binary (e.g., OK/NOK) or a more advanced classification based on measurement binning or patterns. The link models tie the physics driven functional indicators to observed on-product impact for specific user applications and way of working. The categorical indicators 530 aggregate the functional indicators 525 according to the physics of the system. In the specific example shown here, there are three levels or hierarchies of categorical indicators, a first level 535, second level 540 and third level 545. This is purely an example, and in other embodiments, the first level or second level could be used as the output advice in the decision making, and/or there could be any number of levels.

In the specific example shown here (purely for illustration), the first level comprises overlay contributors (for example, one overlay contributor 535a may be a reticle align contributor to X direction intra-field overlay Ovx,ia, another 535b may be a reticle align contributor to Y direction inter-field overlay OVy,ir, and yet another 535c a leveling contributor to inter-field CD, CDir). The second level categorical indicators 540 aggregates the first level categorical indicators 535 in terms of direction (X and Y) and inter-field ir versus intra-field ia for overlay Ov and in terms of inter-field ir versus intra-field ia for CD. The third level categorical indicators 545 comprise an Overlay indicator Ov (e.g., is overlay OK/NOK) and a CD indicator CD (e.g., is CD OK/NOK). The categorical indicators mentioned above are purely for example, and any suitable alternative indicators may be used, including user-customized health indicators. The only condition is that the indicator be categorizable, can be linked to the functional indicators of layer 525, and that sufficient data can be generated to train the model.

These indicators 545 can then be used to provide advice and/or make process decisions 550, such as whether to inspect and/or rework a substrate. For example, if overlay is deemed to be NOK, it may trigger a decision to inspect and rework the substrate to prevent yield loss. Another example, specific to EUV, is to train the model to determine when EUV source collector contamination results in an LCDU value which is not acceptable. Acceptability criteria shall be learned by the system.

The categorical indicators 530 may be derived from models/simulators based on machine learning techniques. Such a machine learning model can be trained with historical data (prior indicator data) labeled according to its appropriate category (i.e., should it be reworked). The labeling can be based on expert data (e.g., from user input) and/or (e.g., based on) measurement results, such that the model is taught to provide effective and reliable prediction of substrate quality based on future numerical data inputs from scanner data. The system categorical indicator training may use, for example, feedforward neural network, random forest, and/or deep learning techniques. Note that the FDC system does not need to know about any user sensitive data for this training; only a higher-level categorization, tolerance and/or decision (e.g., whether or not a substrate would be reworked) is required.

As such, an artificial intelligence model may be created which uses machine learning techniques (e.g. regression, convolutional neural networks, transfer learning and deep reinforcement learning) and model checking (e.g. SAT and SMT constraint solvers) to automatically adapt the indicator control limits/thresholds or predictions. The learning is validated and reinforced by building a feedback loop between the model which predicts certain values (e.g. OVL X is OK/NOK) and verification data which verifies whether the prediction was accurate (e.g., comprises the categorical values which the model/FDC system should have predicted). This may be achieved in a verification stage 510, in which inspection/metrology data 555 (numerical metrology data, suffixed m) is measured. The verification are the values that should have been predicted by the Model (e.g. OVL X is OK). By feeding that information back 560 to the model, the model can adapt to match the results observed by the customer, e.g., by changing a threshold value in one or more of its categorical models. The model is therefore versatile in the sense that a process-specific balancing between decision is transferred to the threshold utilized by the machine learning model to decide whether a wafer should be reworked or not.

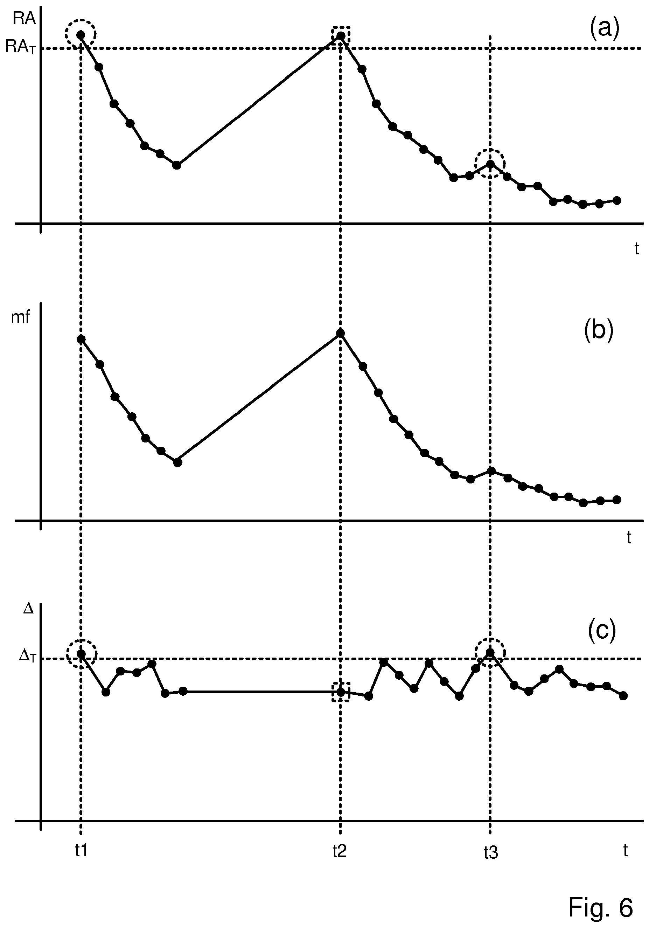

Figure 6 comprise three plots which illustrate the deriving of the functional and categorical indicators, and their effectiveness over the statistical indicators used presently. Figure 6(a) is a plot of raw parameter data, more specifically reticle align (RA) against time t. Figure 6(b) is an equivalent (e.g., for reticle align) non-linear model function (or fit) mf derived according to methods described herein. As described, such a model can be derived from knowledge of the scanner physics, and can further be trained on production data (e.g., reticle align measurements performed when performing a specific manufacturing process of interest). The training of this model may use statistical, regression, Bayesian learning or deep learning techniques, for example. Figure 6(c) comprises the residual Δ between the plots of Figure 6(a) and Figure 6(b) which can be used as the functional indicator of the methods disclosed herein. One or more thresholds Δ_{T} can be set and/or learned (e.g., initially based on user knowledge/ expert opinion and/or training as described), thereby providing a categorical indicator. In particular, the threshold(s) Δ_{T} is/are learned by categorical classifier block 530 during the training phase which trains the categorical classifier. It may be that these threshold values are actually unknown or hidden (e.g., when implemented by a neural network.

Values for the functional indicator or residual Δ can therefore be directly input to the categorical classifier which then predicts the appropriate category (e.g., OK or NOK). In this case all points below the threshold Δ_{T} are deemed OK, and the points (i.e., in this example at times t1 and t3) above the threshold Δ_{T} are deemed NOK.

It is instructive to compare this to the statistical control technique which is typically employed on the raw data at present. Setting a statistical threshold RA_{T} to the raw data of Figure 6(a) will result in the outlier at time t1 being identified, but not that at time t3. Furthermore, it will incorrectly identify the point at time t2 as an outlier, when in fact it is not (i.e., it is OK) according to the categorical indicator disclosed herein (illustrated in Figure 6(c)).

As such, a decision making method/system is described herein, for which the number of false positives and negatives will decrease. The improved prediction functionality results from the use of new indicators derived from scanner physics, and that the criteria (thresholds) for setting a categorical indicator value are determined and learned from actual product use cases. Threshold/ control limit maintenance is replaced by the automated (no human intervention required) validation feedback loop described, i.e., by monitoring indicator accuracy. Furthermore, the feedback loop can be as close as possible to the scanner to prevent noise introduced by other process steps. The decision model therefore comprises a single model which integrates physics models and machine learning models and automatically adapts its predictions from user application.

It should be appreciated that deviation from nominal is only one possible way to determine an indicator (e.g., OK/NOK). The concepts herein are more generally applicable. For example, they can be used to cluster Scanner behaviors (e.g., into different classes). Provided that a user can label the data with sufficiently high accuracy and has sufficient data for training, each user could have different labels for the same model.

Further embodiments of the invention are disclosed in the list of numbered clauses below:
1. A method for making a decision within a manufacturing process, the method comprising:
   obtaining scanner data relating to one or more parameters of a lithographic exposure step of the manufacturing process;
   applying a decision model which outputs a value for each of one or more categorical indicators based on the scanner data, each of the one or more categorical indicators being indicative of a quality of the manufacturing process; and
   deciding on an action based on a value of the categorical indicator.
2. A method according to clause 1, wherein the scanner data is generated by a lithographic apparatus during the lithographic exposure step.
3. A method according to clause 1, wherein the scanner data is measured during a maintenance action.
4. A method according to any preceding clause, wherein each of the one or more categorical indicators is derived from one or more functional indicators.
5. A method according to clause 4, wherein each of the one or more functional indicators are determined from one or more functional models based on known physics related to the lithographic exposure step and/or an associated apparatus.
6. A method according to clause 4 or 5, wherein the one or more functional indicators comprise at least one functional indicator which describes a deviation of a parameter value from nominal behavior, said nominal behavior being derived from said known physics.
7. A method according to clause 4, 5 or 6, wherein each of the one or more functional indicators is trained using one or more of: statistical technique, optimization, regression, or a machine learning technique.
8. A method according to any of clauses 4 to 7, wherein each of the one or more categorical indicators is derived from said one or more functional indicators by categorizing the functional indictors according to one or more applied and/or learned threshold values to the one or more functional indicators.
9. A method according to clause 8, comprising training the decision model on measurements performed on substrates having undergone said lithographic exposure step and corresponding decisions and/or categories assigned thereto, said training setting each of said one or more threshold values.
10. A method according to clause 9, wherein the training the decision model uses a machine learning technique comprises one or more of: a neural network technique, random forest technique and a deep learning technique.
11. A method according to any of clauses 8 to 10, comprising measuring substrates subsequent to said value for the categorical indicator output by the decision model, and validating the decision model output based on the measurements.
12. A method according to clause 11, wherein the validation step comprises altering one or more of said threshold values to improve prediction performance of the decision model.
13. A method according to any of clauses 4 to 12, wherein said one or more categorical indicators are each derived from an aggregation of multiple functional indicators.
14. A method according to clause 13, wherein the aggregation comprises aggregating multiple intermediate categorical indicators derived from the multiple functional indicators.
15. A method according to any preceding clause, wherein each of said one or more categorical indicators comprises a binary categorical indicator describing whether the parameter is within specification or otherwise.
16. A method according to any preceding clause, wherein each of said one or more categorical indicators relates to one or more of overlay, focus, critical dimension, critical dimension uniformity.
17. A method according to any preceding clause, wherein the decision comprises deciding whether the substrate should be inspected as a possible candidate for rework.
18. A method for constructing a decision model for making a decision within a manufacturing process, the method comprising:
   obtaining scanner data relating to one or more parameters of a lithographic exposure step of the manufacturing process;
   deriving one or more categorical indicators from the scanner data, each of the one or more categorical indicators being indicative of a quality of the manufacturing process based on at least one threshold value; and
      training the decision model on measurements performed on substrates having undergone said lithographic exposure step and corresponding decisions and/or categories assigned thereto, said training setting a value for each of said one or more threshold values, such that said decision model outputs an appropriate value for each of the one or more categorical indicators based on said scanner data.
19. A method according to clause 18, wherein said training the decision model is also based on expert knowledge.
20. A method according to clause 18 or 19, wherein said training of the model uses a machine learning technique comprising one or more of a neural network technique, random forest technique or a deep learning technique.
21. A method according to clause 18, 19 or 20 wherein each of the one or more categorical indicators is derived from one or more functional indicators.
22. A method according to clause 21, wherein each of the one or more functional indicators are determined from one or more functional models based on known physics related to the lithographic exposure step and/or an associated apparatus.
23. A method according to clause 21 or 22, wherein the one or more functional indicators comprise at least one functional indicator which describes a deviation of a parameter value from nominal behavior, said nominal behavior being derived from said known physics.
24. A method according to clause 21, 22 or 23, wherein each of the one or more functional indicators is trained using one or more of: statistical technique, optimization, regression, or a machine learning technique.
25. A method according to any of clauses 21 to 24 wherein each of the one or more categorical indicators is derived from said one or more functional indicators by the application of the one or more threshold values to the one or more functional indicators.
26. A method according to any of clauses 21 to 25, wherein said one or more categorical indicators are each derived from an aggregation of multiple functional indicators.
27. A method according to clause 26, wherein the aggregation comprises aggregating multiple intermediate categorical indicators derived from the multiple functional indicators.
28. A method according to any of clauses 18 to 27, wherein each of said one or more categorical indicators comprises a binary categorical indicator describing whether the parameter is within specification or otherwise.
29. A method according to any of clauses 18 to 28, wherein each of said one or more categorical indicators relates to one or more of overlay, focus, critical dimension, critical dimension uniformity.
30. A computer program comprising program instructions operable to perform the method of any of clauses 1 to 29, when run on a suitable apparatus.
31. A non-transient computer program carrier comprising the computer program of clause 30.
32. A processing system comprising a processor and a storage device comprising the computer program of clause 30.
33. A lithographic apparatus comprising the processing system of clause 30.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method for making a decision within a manufacturing process, the method comprising:
obtaining scanner data relating to one or more parameters of a lithographic exposure step of the manufacturing process;
applying a decision model which outputs a value for each of one or more categorical indicators based on the scanner data, each of the one or more categorical indicators being indicative of a quality of the manufacturing process; and
deciding on an action based on a value of the categorical indicator.

2. A method as claimed in claim 1, wherein each of the one or more categorical indicators is derived from one or more functional indicators determined from one or more functional models based on known physics related to the lithographic exposure step and/or an associated apparatus.

3. A method as claimed in claim 2, wherein the one or more functional indicators comprise at least one functional indicator which describes a deviation of a parameter value from nominal behavior, said nominal behavior being derived from said known physics.

4. A method as claimed in claim 2 or 3, wherein each of the one or more functional indicators is trained using one or more of: statistical technique, optimization, regression, or a machine learning technique.

5. A method as claimed in any of claims 2 to 4, wherein each of the one or more categorical indicators is derived from said one or more functional indicators by categorizing the functional indicators according to one or more applied and/or learned threshold values to the one or more functional indicators.

6. A method as claimed in claim 5, comprising training the decision model on measurements performed on substrates having undergone said lithographic exposure step and corresponding decisions and/or categories assigned thereto, said training setting each of said one or more threshold values.

7. A method as claimed in claim 6, wherein the training the decision model uses a machine learning technique comprises one or more of: a neural network technique, random forest technique and a deep learning technique.

8. A method as claimed in any of claims 5 to 7, further comprising measuring substrates subsequent to said value for the categorical indicator output by the decision model, and validating the decision model output based on the measurements.

9. A method as claimed in claim 8, wherein the validation step comprises altering one or more of said threshold values to improve prediction performance of the decision model.

10. A method as claimed in any preceding claim, wherein each of said one or more categorical indicators relates to one or more of overlay, focus, critical dimension, critical dimension uniformity.

11. A method as claimed in any preceding claim, wherein the decision comprises deciding whether the substrate should be inspected as a possible candidate for rework.

12. A method for constructing a decision model for making a decision within a manufacturing process, the method comprising:
obtaining scanner data relating to one or more parameters of a lithographic exposure step of the manufacturing process;
deriving one or more categorical indicators from the scanner data, each of the one or more categorical indicators being indicative of a quality of the manufacturing process based on at least one threshold value; and
training the decision model on measurements performed on substrates having undergone said lithographic exposure step and corresponding decisions and/or categories assigned thereto, said training setting a value for each of said one or more threshold values, such that said decision model outputs an appropriate value for each of the one or more categorical indicators based on said scanner data.

13. A method as claimed in claim 12, wherein said training the decision model is also based on expert knowledge.

14. A computer program comprising program instructions operable to perform the method of any of claims 1 to 13, when run on a suitable apparatus.

15. A processing system comprising a processor and a storage device comprising the computer program of claim 14.
